# EUROPEAN PATENT APPLICATION

(11) **EP 3 037 828 A1**
(43) Date of publication of application: **29.06.2016**
(21) Application number: 15201907.1
(22) Date of filing: 22.12.2015
(51) Int. Cl.: G01R 1/067, G01R 31/02

(54) **FAULT DETECTION FOR A FLEXIBLE PROBE TIP**

(30) Priority: 22.12.2014 US 201414579227
(71) Applicant: Tektronix, Inc., Beaverton, Oregon 97077-0001 (US)
(72) Inventor: McGrath, James, Aloha, OR Oregon 97007 (US); Pollock, Ira, Hillsboro, OR Oregon 97123 (US)
(74) Representative: Clarke, Jeffrey David

(57) **Abstract**

A fault detection circuit for a flexible probe tip (200) includes one or more conductive fault detection traces (210) on a flexible substrate (202) which are connected to a fault detector (240) capable of determining if an electrical discontinuity or defect is present in the fault detection traces (210). The fault detector (240) may also include a fault indicator, such as a light, to indicate to a user that it has detected a discontinuity and therefore that flexible probe tip (200) should not be soldered onto the user's device under test. The fault detector (240) may determine that there is a discontinuity in the fault detection traces (210) by checking if the impedance of the fault detection trace (210) changes, or by checking for a drop in voltage from one end of the fault detection trace to the other end, or by using other methods.

## Description

### FIELD OF INVENTION

This disclosure relates to probe tips for a test and measurement instrument probe, and more particularly to probe tips incorporating a flexible circuit.

### BACKGROUND

Users of a test and measurement instrument, such as one of the MSO/DPO70000 Series oscilloscopes manufactured and sold by Tektronix, Inc., connect a device under test (DUT) to the input of the measurement instrument with a probe. As the physical size of a DUT circuit being probed decreases, and as the density of the electrical components in a circuit being probed increases, it becomes more challenging for a user to locate an acceptable space on the circuit to physically connect the probe tip. Additionally, the general trends of ever-increasing signal data rates and lower operating signal voltage levels in circuits create significant technological challenges for probe designers. To meet performance requirements like bandwidth, noise immunity, and sensitivity, probes, such as the P7600 Series probes manufactured and sold by Tektronix, Inc., typically use probe tips that incorporate high-performance coaxial cables to convey measured signals from the DUT. However, this type of high-performance coaxial cable is relatively expensive, which leads to higher purchase prices for probe tips using this type of traditional cable (hereinafter "coax-based probe tip").

One alternative to using a coax-based probe tip is to instead use a probe tip that incorporates a flexible circuit (hereinafter "flex circuit probe tip" or "flexible probe tip") to convey measured signals. The benefits of using a flexible probe tip rather than a coax-based probe tip include reducing probe tip cost, as well as giving users more freedom in positioning a probe tip on their DUTs. A flex circuit probe tip allows a user to bend the probe tip around components on the circuit that would obstruct the vertical clearance area ordinarily required for a traditional coax-based probe tip. But, the inherent pliability of a flexible circuit can also be a detriment in this application. Due to the bending that a flex circuit probe tip is likely to endure during normal use, a flex circuit probe tip will have a limited usable lifespan and will eventually wear-out. The lifespan of a flex circuit probe tip will depend on the severity of bending and the number of bend cycles to which it is subjected.

Because a flex circuit probe tip has a significantly lower cost compared to a coax-based probe tip, the limited lifespan of a flex circuit probe tip may not be a great problem in terms of overall lifetime probe cost to a user, since the flex circuit probe tip essentially becomes a "wear-out" item that can be replaced by a user at regular preventative maintenance intervals, and several flex circuit probe tips can be purchased for less than the cost of a traditional coax-based probe tip.

However, a remaining potential problem with a flex circuit probe tip relates to the process of attaching the probe tip to the DUT. To create good electrical contact between the DUT and the probe tip, and to ensure good fidelity of measured signals, users typically attach a probe tip to their circuits by soldering the probe tip in place. Due to the ever-increasing density of users' circuits, as well as the ever-smaller size of the components used in those circuits, soldering a probe tip in place can be a challenging task requiring great skill, precision, and patience. Users can sometimes spend hours, or even days, soldering a probe tip in place. Because of this potentially heavy investment of a user's time and effort, it is extremely problematic for a user to spend the time soldering a flex circuit probe tip in place, only to discover later when trying to actually measure signals that the probe tip had already worn-out and was no longer functional.

Embodiments of the invention address these and other limitations of the prior art.

### SUMMARY OF THE INVENTION

A fault detection circuit for a flexible probe tip includes one or more conductive fault detection traces on a flexible substrate. The fault detection traces are connected to a fault detector capable of determining if an electrical discontinuity is present in the fault detection traces. The fault detector may also include a fault indicator, such as a light, to indicate to a user that it has detected a discontinuity. The fault detector may determine that there is a discontinuity in the fault detection traces by checking if the impedance of the fault detection trace changes, or by checking for a drop in voltage from one end of the fault detection trace to the other end, for example.

### BRIEF DESCRIPTION OF THE DRAWINGS

FIG. 1 illustrates a measurement system including a flexible probe tip according to embodiments of the invention.
FIG. 2 is a perspective view of a flexible probe tip including a fault detection circuit according to embodiments of the invention.
FIGS. 3A, 3B, and 3C are top-view diagrams of various example paths for fault detection traces used in the flexible probe tip according to embodiments of the invention.
FIG. 4 is cross-sectional diagram of a portion of a flexible probe tip incorporating a multiple-layer flexible circuit according to embodiments of the invention.
FIGS. 5A and 5B are diagrams that illustrate that the fault detector may be located separate from the probe tip, according to embodiments of the invention.

### DETAILED DESCRIPTION OF THE INVENTION

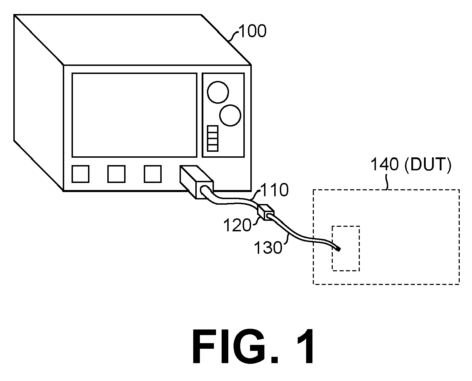

FIG. 1 depicts a typical system for probing signals on a DUT. A test and measurement device 100, such as an oscilloscope, is connected to a probe 110. The probe 110 includes a probe tip connector 120 that connects to a flexible probe tip 130. The flexible probe tip 130 maybe connected to the DUT 140, for example, by being soldered into place on a portion of the circuitry being tested. The test and measurement instrument 100 may supply power and control signals to the probe 110 and the flexible probe tip 130. The flexible probe tip 130 and the probe 110 convey the signals probed on the DUT to the test and measurement instrument 100 for analysis.

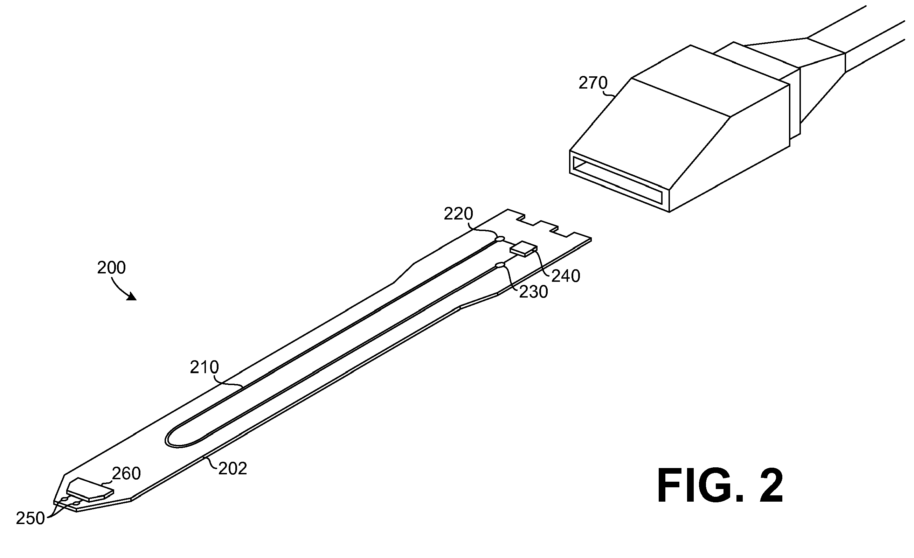

FIG. 2 is a perspective view of a probe tip connector 270 capable of connecting to a flexible probe tip 200 according to embodiments of the invention. The flexible probe tip 200 may be based (or formed) on a non-conductive flexible substrate 202. A conductive trace 210 is formed on the flexible substrate 202. The flexible substrate 202 and the conductive trace 210 can be a flexible circuit manufactured using known materials and processes. For example, the conductive trace 210 may be made from copper, copper alloy, silver, or other conductive material, and the flexible substrate 202 may be made from a type of flexible plastic such as polyester or, preferably, a polyimide such as Kapton™. A layer of insulating material (not shown) may be laminated over the conductive trace 210. Conductive attachment points 250, for soldering the flexible probe tip 200 to a DUT, and additional circuitry, such as signal-conditioning circuitry 260, can also be placed on the flexible substrate 202. The flexible probe tip 200 may have additional conductive traces (not shown) that are structured to convey signals probed on the DUT from the conductive attachment points 250, through the signal-conditioning circuitry 260, to the probe tip connector 270. The flexible probe tip 200 may also have other conductive traces (not shown) that are structured to convey power and control signals from the probe tip connector 270 to various electrical components on the flexible probe tip 200.

The conductive trace, or fault detection trace 210, provides an electrical path between a first endpoint, or node 220, and a second endpoint, or node 230. The trace may be formed with an impedance in the range of 50-100 ohms, and, more preferably, between 75-80 ohms, for example. In the embodiment depicted by FIG. 2, the fault detection trace 210 forms an elongated "U" shape running along substantially the length of the flexible probe tip 200. A fault detector 240 is electrically coupled between the endpoints 220, 230. The fault detector 240 is structured or configured to detect or measure electrical continuity in the electrical path formed by fault detection trace 210.

During normal use, a user will likely repeatedly bend the flexible probe tip 200. Due to the inherent thinness of the flexible substrate 202, typically between 12 µm to 125 µm, this bending will generally be about an axis that is perpendicular to the longitudinal axis of the flexible probe tip 200. Thus, in some embodiments of the invention, the fault detection trace 210 traverses this axis of bending and is therefore subjected to physical strain when the flexible probe tip 200 is bent. After repeated or severe bending, the fault detection trace 210 will eventually develop an electrical discontinuity; that is, the fault detection trace 210 will likely develop an open-a break in the electrical path-or, if not a complete open, at least develop a measurable change of impedance. In some embodiments, the fault detection trace 210 is formed to develop a discontinuity after between tens to hundreds of bend cycles.

The fault detector 240 detects whether there is a discontinuity at any point or points in the fault detection trace 210. In some embodiments the fault detector 240 detects a discontinuity by determining if an impedance of the fault detection trace 210 is outside of an acceptable range. In other embodiments the fault detector 240 detects a discontinuity by applying a voltage at the first endpoint 220, measuring the voltage at the second endpoint 230, comparing the measured voltage to the applied voltage, and determining if the difference between these voltages exceeds a selectable threshold value. In some embodiments the fault detector 240 may include a microprocessor, Field Programmable Gate Array (FPGA), discrete circuitry, or any combination thereof.

The fault detector 240 may use different detection methods depending on implementation. In some embodiments the fault detector 240 may determine a DC resistance of the fault detection trace 210. Such an embodiment is straightforward and relatively easy to implement. In other embodiments the fault detector 240 may determine an AC inductance. In such an embodiment one end of the fault detection trace is shorted to AC ground. In a third embodiment the fault detector 240 may determine an AC capacitance of the fault detection trace 210. In such an embodiment one end of the fault detection trace 210 is left as an open circuit. The AC capacitance method requires more circuitry than the others to implement, but includes the feature of being able to generally detect a location on the fault detection trace where the fault or discontinuity occurred. Finally, the fault detector 240 may use Time-Domain Reflectometry (TDR). Using such technology allows the fault detector to accurately determine the location of the fault or discontinuity, and additionally estimate the severity of the fault. However, a TDR system may be relatively expensive to implement in terms of hardware and software costs.

In some embodiments the fault detector 240 is further configured to provide a fault indication to a user when the fault detector 240 detects a discontinuity or other defect in the electrical path formed by the fault detection trace 210. The indication provided to the user may be a visual indication such as a light, an aural indication such as a beep, or a haptic indication such as a vibration. According to some embodiments, when a discontinuity is detected, the fault detector 240 alerts the user to the fault by changing the state of a light-emitting diode (LED), such as one placed on the flexible probe tip 200. For example, the fault detector 240 may turn on an LED, or may change the color of an LED, e.g. from green to red, to indicate that a fault is present. In other embodiments, the fault detector 240 is structured to provide a fault detection signal to the flexible probe tip connector 270. Such a fault detection signal may then be conveyed through an attached probe to an attached test and measurement device, and may be used to generate a message displayed on a display screen of the test and measurement device as the fault indication.

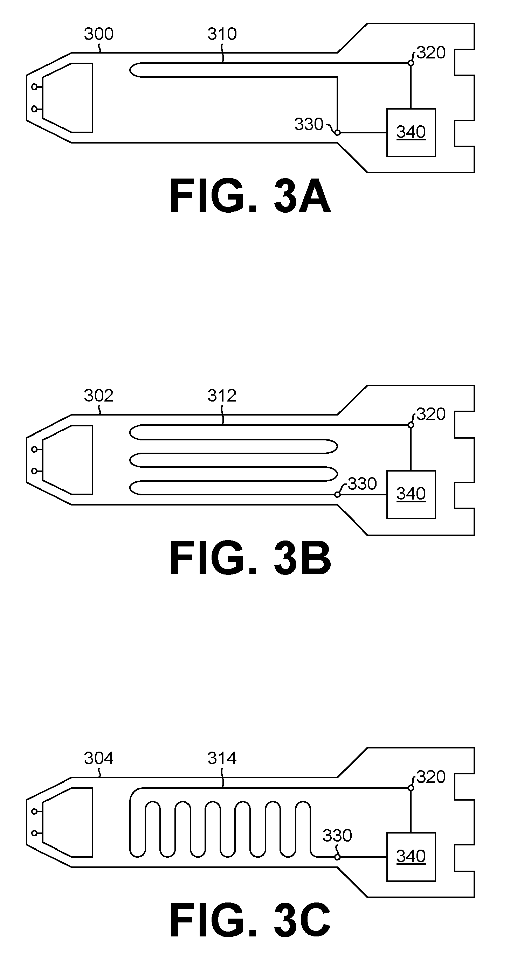

A fault detection trace may be formed in a multitude of shapes. As examples, FIGS. 3A-3C depict flexible probe tips 300, 302, 304 that have, respectively, fault detection traces 310, 312, 314 formed in three different paths. On each flexible probe tip 300, 302, 304, the fault detection traces 310, 312, 314 are each formed between endpoints 320, 330. A fault detector 340 is also coupled between endpoints 320, 330. The fault detection trace 310 of FIG. 3A is generally formed of an elongated loop. The fault detection trace 312 of FIG. 3B is generally formed of several serpentine loops. The fault detection trace 314 of FIG. 3C is comb-shaped. Of course, other layouts and shapes of the fault detection traces are possible. Preferably, the fault detection trace is structured to traverse areas of the flexible probe tip likely to experience the greatest amount of strain during typical use. For example, the fault detection traces 310, 312, 314 traverse areas of the flexible probe tips 300, 302, 304 that are most likely to be bent. This allows the fault detection traces to more likely develop a detectable electrical discontinuity.

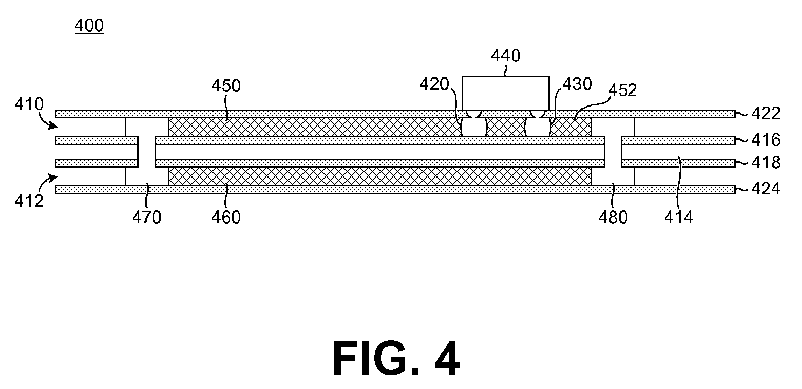

A fault detection trace may also be formed on more than one layer of flexible substrates, such as in a multiple-layer flex circuit. FIG. 4 illustrates a portion of a cross-section of a multiple-layer flexible probe tip 400, according to embodiments of the invention. In the flexible probe tip 400, a center conductive layer 414 is laminated between non-conductive flexible substrate layers 416, 418. A top conductive layer 410 includes conductive traces 450, 452 and a bottom conductive layer 412 includes a conductive trace 460. In the embodiment depicted in FIG. 4, the top and bottom conductive layers 410, 412 are covered, respectively, with non-conductive layers 422, 424. The conductive trace 450 on the top layer is connected to the conductive trace 460 on the bottom layer by a conductive via 470. Likewise, the conductive trace 460 on the bottom layer is connected by a conductive via 480 to the conductive trace 452 on the top layer. In this manner, the conductive traces 450, 452, 460 and the conductive vias 470, 480 together form an electrical path between a first endpoint, or node 420 and a second endpoint, or node 430. Of course, the fault detection traces 450, 452, 460 may be formed in any shape on any conductive layer of a multiple-layer flex circuit, and may take different paths on different layers.

A fault detector 440 may then be coupled between the endpoints 420, 430, which, in some embodiments, may be pads suitable for mounting an electrical device. The fault detector 440 may be a single electrical component or it may be a combination of multiple components, and it may directly or indirectly coupled to the endpoints 420, 430. The fault detector 440 is structured or configured to detect a discontinuity, such as a break or an impedance change, in the loop-like electrical path formed by the conductive traces 450, 452, 460 and the conductive vias 470,480.

In preferred embodiments, the center conductive layer 414 may contain conductive traces (not shown) to convey probed signals from a user's DUT to an attached probe (not shown). In a multiple-layer flexible circuit, the outermost layers will tend to experience the greatest amount of strain due to bending of the flexible circuit. Therefore, by placing probed signal traces on the interior conductive layer 414 of the flexible probe tip 400, and by having the fault detection traces-conductive traces 450, 452, 460-n the outermost conductive layers 410, 412, any discontinuity detected by the fault detector 440 will generally provide an early warning to a user that the flexible probe tip 400 is soon to become compromised and should not be used.

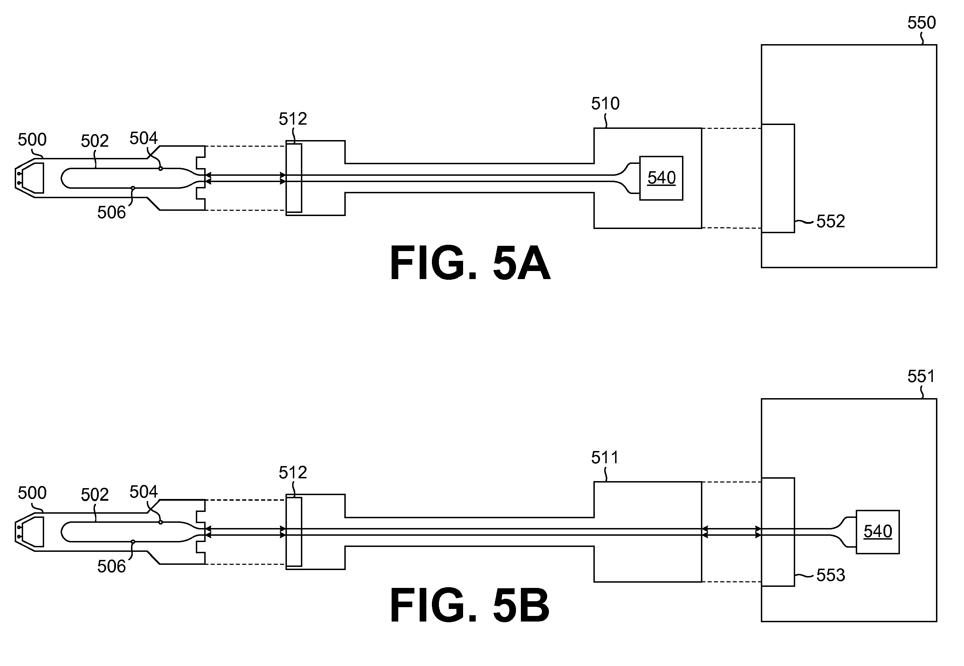

In the embodiments discussed above, a fault detector is physically located on the flexible probe tip itself. However, in other embodiments, a fault detector may instead be physically located in an attached probe, or in an attached test and measurement device. FIG. 5A illustrates an embodiment in which a probe 510 is connectable to a test and measurement device 550 through a probe connector 552. A flexible probe tip 500 is connectable to the probe 510 and has a fault detection trace 502 formed between two endpoints 504, 506. A fault detector 540 is physically located in the probe 510, and is coupled between the endpoints 504, 506 when the flexible probe tip 500 is connected to a flexible probe tip connector 512 that is part of the probe 510. In this manner, when the flexible probe tip 500 is connected to the flexible probe tip connector 512, the fault detector is able to determine whether there is a discontinuity or defective condition in fault detection trace 502.

Likewise, FIG. 5B illustrates another alternative embodiment in which the flexible probe tip 500 that has the fault detection trace 502 between the endpoints 504, 506 is connectable to a probe 511 through the flexible probe tip connector 512. The probe 511 is connectable to a test and measurement device 551 through a probe connector 553. The fault detector 540 is physically located in the test and measurement device 551, and is coupled between the endpoints 502, 504 when the flexible probe tip 500, the probe 511, and the test and measurement device 551, are connected together.

Although specific embodiments of the invention have been illustrated and described for purposes of illustration, various modifications may be made without departing from the scope of the invention. Accordingly, the invention should not be limited except as by the appended claims.

Examples provide a fault detection circuit for a flexible probe tip that is connectable to a probe for a test and measurement device, the fault detection circuit comprising a flexible substrate, at least one conductive trace disposed on the flexible substrate as an electrical path having a first endpoint and a second endpoint and a fault detector electrically coupled between the first endpoint and the second endpoint, and configured to detect an electrical discontinuity in the electrical path.

In some examples the flexible substrate further comprises a flex circuit.

In some examples the flex circuit comprises a single conductive layer.

In some examples the flex circuit comprises a multiple-layer flex circuit having a top conductive layer and a bottom conductive layer.

In some examples at least one conductive trace comprises a first trace disposed on the top conductive layer, a second trace disposed on the bottom conductive layer and at least one via electrically coupled between the first trace and the second trace.

In some examples the fault detector is disposed on the flexible substrate.

In some examples the fault detector is disposed in the probe.

In some examples the fault detector is disposed in the test and measurement device.

In some examples the fault detector comprises a microprocessor.

In some examples the fault detector comprises a fault indicator structured to generate an indication to a user of the electrical discontinuity.

In some examples the indication comprises a visual indication.

In some examples the fault indicator comprises a light-emitting diode.

In some examples the visual indication comprises a message displayed on a display screen of the test and measurement device.

In some examples the indication comprises an aural indication.

In some examples the indication comprises a haptic indication.

Examples provide a method of detecting a potential fault in a flexible probe tip for a test and measurement device, the method comprising detecting a physical discontinuity in an electrical path that traverses a portion of the flexible probe tip.

In some examples detecting a physical discontinuity comprises detecting that an impedance of the electrical path is outside of a selectable range.

In some examples detecting a physical discontinuity comprises applying a first voltage to a first node of the electrical path, measuring a second voltage at a second node of the electrical path, comparing the second voltage to the first voltage and determining whether the difference between the second voltage and the first voltage exceeds a selectable threshold value.

Some examples further comprise alerting a user of the detected physical discontinuity.

In some examples alerting a user of the detected physical discontinuity comprises changing the state of a light-emitting diode.

## Claims

1. A fault detection circuit for a flexible probe tip that is connectable to a probe for a test and measurement device, the fault detection circuit comprising:
a flexible substrate;
at least one conductive trace disposed on the flexible substrate as an electrical path having a first endpoint and a second endpoint; and
a fault detector electrically coupled between the first endpoint and the second endpoint, and configured to detect an electrical discontinuity in the electrical path.

2. The fault detection circuit of claim 1 in which the flexible substrate further comprises a flex circuit.

3. The fault detection circuit of claim 2 in which the flex circuit comprises a single conductive layer or a multiple-layer flex circuit having a top conductive layer and a bottom conductive layer.

4. The fault detection circuit of claim 3 in which the at least one conductive trace comprises:
a first trace disposed on the top conductive layer;
a second trace disposed on the bottom conductive layer; and
at least one via electrically coupled between the first trace and the second trace.

5. The fault detection circuit of any preceding claim in which the fault detector is disposed on the flexible substrate or disposed in the probe.

6. The fault detection circuit of any preceding claim in which the fault detector is disposed in the test and measurement device.

7. The fault detection circuit of any preceding claim in which the fault detector comprises a microprocessor.

8. The fault detection circuit of any preceding claim in which the fault detector comprises a fault indicator structured to generate an indication to a user of the electrical discontinuity.

9. The fault detection circuit of claim 8 in which the indication comprises a visual indication, an aural indication and/or a haptic indication.

10. The fault detection circuit of claim 9 in which the fault indicator comprises a light-emitting diode.

11. The fault detection circuit of claim 9 in which the visual indication comprises a message displayed on a display screen of the test and measurement device.

12. A method of detecting a potential fault in a flexible probe tip for a test and measurement device, the method comprising:
detecting a physical discontinuity in an electrical path that traverses a portion of the flexible probe tip.

13. The method of claim 12 in which detecting a physical discontinuity comprises:
detecting that an impedance of the electrical path is outside of a selectable range; and/or
applying a first voltage to a first node of the electrical path;
measuring a second voltage at a second node of the electrical path;
comparing the second voltage to the first voltage; and
determining whether the difference between the second voltage and the first voltage exceeds a selectable threshold value.

14. The method of claim 12 or 13, further comprising:
alerting a user of the detected physical discontinuity.

15. The method of claim 14 in which alerting a user of the detected physical discontinuity comprises changing the state of a light-emitting diode.
